(19) Europäisches Patentamt
European Patent Office
Office européen des brevets

(11) **EP 3 157 219 B1**

(12) **EUROPEAN PATENT SPECIFICATION**

(45) Date of publication and mention
of the grant of the patent:
**13.06.2018 Bulletin 2018/24**

(51) Int Cl.:
**H04L 27/06** (2006.01)       **H03K 3/013** (2006.01)
**H03K 5/24** (2006.01)        **H03K 17/00** (2006.01)
**H04L 25/02** (2006.01)

(21) Application number: **16154322.8**

(22) Date of filing: **04.02.2016**

(54) **DEMODULATION OF ON-OFF MODULATED SIGNALS IN SIGNAL ISOLATOR SYSTEMS**

DEMODULATION VON EIN-AUS-MODULIERTEN SIGNALEN IN SIGNALISOLATORSYSTEMEN

DÉMODULATION DE SIGNAUX MODULÉS ON-OFF DANS DES SYSTÈMES D'ISOLATION DE SIGNAUX

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **14.10.2015 US 201514883342**

(43) Date of publication of application:
**19.04.2017 Bulletin 2017/16**

(73) Proprietor: **Analog Devices, Inc.**
**Norwood, MA 02062-9106 (US)**

(72) Inventors:
• **YUN, Ruida**
  **Weston, MA 02493 (US)**

• **GAALAAS, Eric C.**
  **Bedford, MA 01730 (US)**
• **CHEN, Baoxing**
  **Westford, MA 01886 (US)**

(74) Representative: **Mears, Andrew David**
**Withers & Rogers LLP**
**4 More London Riverside**
**London SE1 2AU (GB)**

(56) References cited:
**EP-A1- 1 753 129**       **WO-A2-97/17763**
**US-A1- 2006 202 721**    **US-B1- 6 208 174**
**US-B1- 8 502 584**

**Description**

BACKGROUND

The present invention relates to signal isolators and, particularly, signal isolators that operate according to an on-off keyed signal protocol.
Isolators are devices that exchange data signals between two galvanically isolated circuit systems. The two circuit systems each operate in different voltage domains, which may include different supply voltages and different ground references. Isolation devices may provide data exchange across an isolation barrier, which maintains the galvanic isolation. Typical isolation devices include micro-transformers, capacitors, magneto-resistors/giant magneto-resistors and opto-electronic devices.
On-off keying ("OOK") is a signaling protocol that identifies a digital state of input data based on the type of signal that is transmitted through the isolation barrier. A first digital data state (say, a digital "1") might be signaled by transmitting a periodic signal across the isolation barrier. A second digital data state (a digital "0") might be signaled by transmitting no signal across the isolation barrier. A receiver circuit would detect the presence or absence of the periodic signal and decode a digital output signal therefrom.
OOK-based signal isolators typically have inefficient designs. For example, isolator receivers may include a multiplier (or mixer) and an integrator as an energy detector for OOK demodulation. A mixer, however, has a limited ability to handle common mode noise. Integrators typically are very slow for applications that require high data rate transmission across the isolation barrier.
Accordingly, the inventors perceive a need in the art for an improved receiver that provides improved speed and improved noise immunity.
United States patent application publication no. 2006/202721 discloses that a system and method is provided for extending the range of a common mode voltage of a differential comparator. In one embodiment, a differential comparator comprises an input stage with a negative voltage reference node, a first differential input coupled to a first differential pair transistor and operative to receive a first input signal, and a second differential input coupled to a second differential pair transistor and operative to receive a second input signal. The first input signal and the second input signal form a differential input signal. The differential comparator further comprises a common mode sensing circuit interconnected between the first differential input, the second differential input, and the negative voltage reference node.; The common mode sensing circuit is operative to sense a common mode voltage of the differential input signal and set a voltage potential at the negative voltage reference node substantially equal to the sensed common mode voltage.
International patent application publication no. WO9717763 discloses that a receiver device comprises two input circuits, connected in parallel, for receiving digital information in the form of electrical differential binary signals within a broad range of common-mode voltages. The input circuits in turn comprise transistors (14, 15, 16, 17, 24, 25) in differential input arrangements for receiving said signals. Said transistors (14, 15, 16, 17, 24, 25) of both input circuits are of one and the same type, whereby the receiver device is capable of handling higher speeds. Controlled activation and deactivation of a first one of said input circuits further enhances the speed capabilities of the receiver device.
European patent application publication no. EP1753129 discloses that a differential signal receiver has a common mode suppression circuit having resistive inputs (R1, R2), and a current mirror circuit (M1-M8) to generate a corrective signal from one input and combine it with a signal from the other of the resistive inputs. The resistive inputs mean input range is no longer limited to the supply rails, and the corrective signal enables common mode suppression without attenuation of the differential component. The current mirror has a transistor in each input path, so that a voltage drop across a first of the input resistors is coupled to a gate or base of the transistor in the other of the input paths. The characteristics of the transistors and the values of the resistors are selected so that the corrective signal has an amplitude and timing to suppress the common mode component. It can be used for LVDS signals.
United States patent no. 8502584 discloses a circuit that includes an amplifier circuit disposed between an isolation link and a Schmitt trigger circuit to amplify a differential signal communicated over the isolation link and supply the amplified signal to the Schmitt trigger circuit. In turn, the Schmitt trigger circuit is coupled to the amplifier circuit to receive the differential signal and to supply a differential output signal corresponding to the differential signal communicated over the isolation link.

BRIEF DESCRIPTION OF THE DRAWINGS

FIG. 1 illustrates an isolator system.

FIG. 2 illustrates a receiver.

FIG. 3 illustrates exemplary signals that may be processed by the receiver of FIG. 2.

FIG. 4 illustrates a current comparator.

FIG. 5 illustrates exemplary signals that may be processed by the comparator of FIG. 4.

FIG. 6 illustrates a receiver.

FIG. 7 illustrates an output driver.

FIG. 8 illustrates a receiver.

FIG. 9 illustrates a receiver according to an embodiment of the present invention.

FIG. 10 illustrates exemplary signals that may be processed by the receiver of FIG. 9.

## DETAILED DESCRIPTION

The invention provides a receiver system for an OOK isolator system, which includes a pair of receivers. A first receiver generates a first current signal representing a received OOK signal, and a second receiver generates a second current signal from a common mode representation of the received OOK signal. The receiver system includes circuitry to compare the first and second current signals and generate an output signal therefrom.

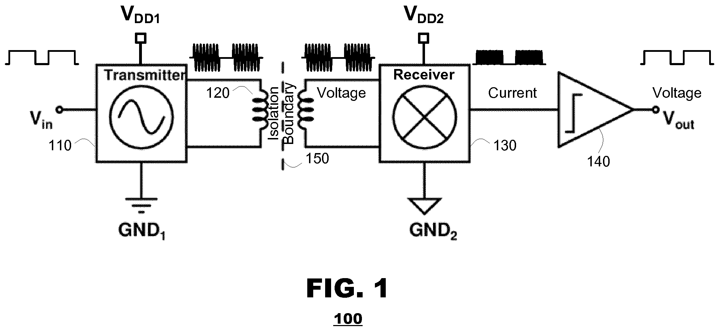

FIG. 1 illustrates an isolator system 100. The system 100 may include a transmitter 110, an isolator 120, a receiver 130 and an output driver 140. The isolator 120 may span an isolation boundary 150, which galvanically isolates two voltage domains from each other. The transmitter 110 may belong to a first voltage domain, which possesses its own voltage and ground supplies (shown as $V_{DD1}$, $GND_1$). The receiver 130 and output driver 140 may belong to a second voltage domain, which possesses voltage and ground supplies ($V_{DD2}$, $GND_2$) separate from the supplies of the first voltage domain. The isolation boundary 150 may prevent communication of voltages from one domain to the other.

The system 100 may be provided for communication of digital data from the first voltage domain to the second voltage domain by on-off keying ("OOK" for short). In such an example, the transmitter 110 may receive an input signal that takes one of two binary voltage levels. The transmitter 110 may generate an output signal having a state that is determined from the state of the input signal. For example, if the input signal corresponds to a binary value of "1," the transmitter 110 may generate a periodic signal as its output but, if the input signal corresponds to a binary value of "0," the transmitter 110 may output an inert signal (no activity). This action of toggling between an active state and an inactive state based on the state of the input signal represents one example of an on-off keyed output.

The isolator 120 may be provided as a micro-transformer (shown in FIG 1), capacitive isolators, magneto-resistive sensors, an optical signal isolator or as Hall effect devices. The isolator 120 may receive the output from the transmitter 110 in the first voltage domain and pass a received signal to the receiver 130 in the second voltage domain. Although the received signal is illustrated as a copy of the OOK output that the isolator 120 receives from the transmitter 110, the received signal may include perturbations (not illustrated) that are induced into the signal by the isolator 120, for example, shifts in voltage, distortions induced by the isolator's temporal response and noise effects. The received signal may be provided to the receiver 130 as a voltage.

The receiver 130 and output driver 140 may form an OOK receiver system in aggregate. The receiver 130 may generate a current signal from the OOK signal supplied to it by the isolator 120. The output driver 140 may generate a voltage signal from the current signal supplied to it by the receiver 130. In an example, the receiver 130 and output driver 140 may exchange current domain signals to provide a low latency output in response to OOK signals provided by the isolator 120.

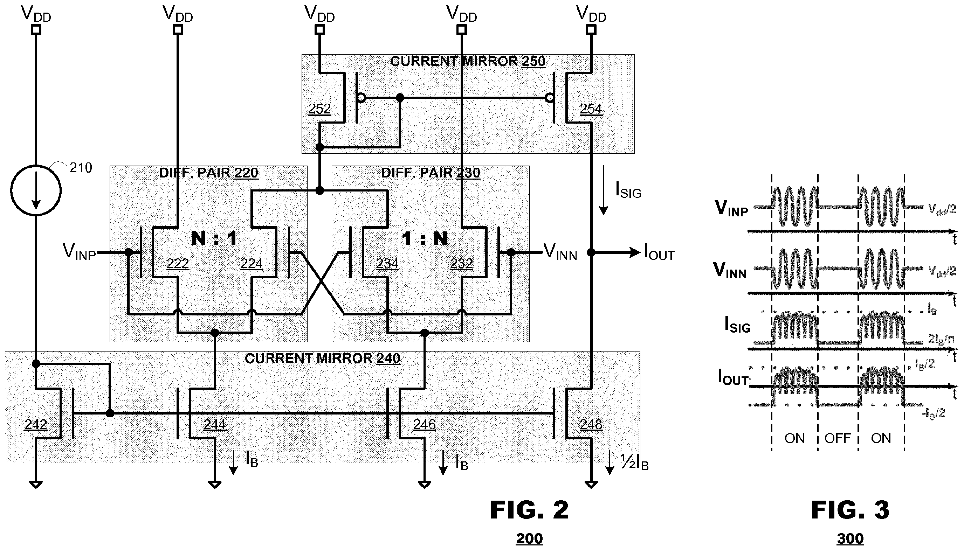

FIG. 2 illustrates a receiver 200, which may be employed as a receiver in the system of FIG. 1. The receiver 200 may include a current source 210, two differential pair circuits 220, 230 and a pair of current mirrors 240, 250.

The differential pair circuits 220, 230 each may include a pair of mismatched transistors 222, 224 for pair 220 and 232, 234 for pair 230. The transistors in each pair 220, 230 may be mismatched according to a predetermined sizing ratio, shown as N to 1. Thus, transistors 222 and 232 may be N times larger than their counterpart transistors 224 and 234. During operation, in response to a common control voltage, the transistors 222, 232 may pass N times more current than the counterpart transistors 224 and 234.

The input signal $V_{IN}$ may be a differential signal represented by component signals $V_{INN}$ and $V_{INP}$. Gates of transistors 222 and 234 may receive a first input voltage $V_{INP}$ and gates of the other transistors 224 and 232 may receive a second input voltage $V_{INN}$. Sources of the transistors 222, 224 in the first differential pair 220 may be connected to a common node, which may be coupled to a transistor 244 within the current mirror 240. Sources of the transistors 232, 234 in the second differential pair 230 may be connected to a second node, which may be coupled to another transistor 246 within the current mirror 240. Drains of the unit-sized transistors 224, 234 of the two differential pairs 220, 230 may be connected together and connected to a first transistor 252 in the second current mirror 250. Drains of the N-sized transistors 222, 232 of the two differential pairs 220, 230 may be connected to voltage supplies $V_{DD}$.

The first current mirror 240 may include a plurality of transistors 242-248 whose gates are connected together. The first transistor 242 may be connected to the current source 210 at its drain. The first transistor 242 also may be configured in a diode-connected configuration. Thus, an amount of current that passes through the first transistor 242 (which is defined by the current source 210) defines the amount of current that passes through the remaining transistors 244-248 of the current mirror 240. The transistors 244-248 may be sized so that twice as much current passes through transistors 244 and 246 as passes through transistor 248 (shown as $I_B$ and $\frac{1}{2}I_B$, respectively).

The second current mirror 250 may include a pair of transistors 252 and 254. As discussed, a first transistor 252 may be connected to the unit-sized transistors 224 and 234 of the differential pairs 220, 230. The second transistor 254 may be connected to the transistor 248 in the first current mirror 240. The first transistor 252 may be provided in a diode-connected configuration. Thus, the current that passes through transistor 252 defines an amount of current that passes through transistor 254.

An output terminal $I_{OUT}$ of the receiver 200 may be provided at the connection between transistors 254 and 248. During operation, the transistors 254 and 248 perform a current comparison at the output terminal $I_{OUT}$. The transistor 248 may sink an amount of current from the output terminal equal to ½$I_B$. The transistor 254 may source an amount of current $I_{SIG}$ to the output terminal in an amount that is determined by the differential pairs 220, 230, which in turn is determined by the input signals $V_{INP}$ and $V_{INN}$. When $I_{SIG} \neq$ ½$I_B$, a residual current is either sourced to or sunk from the output terminal $I_{OUT}$.

In the example illustrated in FIG. 2, the transistors are illustrated as MOSFET transistors and, specifically, transistors 222-224, 232-234 and 242-248 are illustrated as NMOS transistors and transistors 252-254 are illustrated as PMOS transistors. The principles of the present invention apply to transistors of other process technologies, such as BJT transistors and the like. Moreover, as discussed hereinbelow, process types may be inverted (e.g., PMOS transistors may be provided where NMOS transistors are illustrated and NMOS transistors may be provided where PMOS transistors are illustrated) with appropriate inversion of supply voltages.

Such variations are immaterial to the principles of the present invention unless mentioned herein.

FIG. 3 illustrates exemplary input and output signals that may be processed by the receiver of FIG. 2. The input signals $V_{INP}$ and $V_{INN}$ may toggle between two phases of operation according to the OOK signal structure of the system. In a first phase of operation, the OOK signal may be in an "OFF" state in which $V_{INP}$ and $V_{INN}$ are inactive signals. As shown in FIG. 3, $V_{INP}$ and $V_{INN}$ each have voltages of ½$V_{DD}$. In the second phase of operation, the OOK signal may be in an "ON" state in which $V_{INP}$ and $V_{INN}$ are active signals. In the example of FIG. 3, the $V_{INP}$ and $V_{INN}$ signals oscillate between $V_{DD}$ and ground, centered about ½$V_{DD}$. In practice, $V_{INP}$ and $V_{INN}$ may not be full rail signals (e.g., transitioning fully to ground or to $V_{DD}$) owing to losses within the circuit system.

During the OFF state, when $V_{INP}$ and $V_{INN}$ are set to ½$V_{DD}$, the transistors 222, 224, 232, 234 of the differential pairs 220, 230 may become partially conductive. The transistors 222, 232 may source N times as much current to their respective transistors 244, 246 in the current mirror 240 than the transistors 224, 234 do. The current mirror transistors 244, 246 each govern current through the differential pairs 220, 230, limiting the total current through each pair 220, 230 to $I_B$. Thus, transistors 224 and 234 each pass current in the amount of $\frac{1}{N+1}I_B$ and the transistors 222, 232 each pass the remainder of the current $\frac{N}{N+1}I_B$.

In the second current mirror 250, the transistor 252 may source the current that passes through the unit-sized transistors 224, 234. Thus, transistor 252 may pass current in an amount of $\frac{2}{N+1}I_B$. This current may be replicated in transistor 254 $(I_{SIG} = \frac{2}{N+1}I_B)$. The $I_{SIG}$ current may be compared to the current (½$I_B$) that is drained from the output terminal by transistor 248. Thus, the output current may be represented as $I_{OUT} = \frac{2}{N+1}I_B - \frac{1}{2}I_B$. When N is sufficiently large (e.g., N≥ 10), these equations may simplify to:

$$I_{SIG} = \frac{2}{N}I_B,$$

and

$$I_{OUT} = -\frac{1}{2}I_B.$$

During the ON state, $V_{INP}$ and $V_{INN}$ may oscillate between $V_{DD}$ and ground. Conductivity of the transistors 222, 224, 232, 234 of the differential pairs 220, 230 may vary according to these signals. When $V_{INP}$ is at its maximum level, for example, transistors 222 and 234 may be nearly fully conductive. At this same time, $V_{INN}$ will be at its minimum level, which may render transistors 224 and 232 minimally conductive. Thus, transistors 222 and 234 each may pass nearly all of the current ($I_B$) that their associated current mirror transistors 244 and 246 sink. The current passed by transistor 224 may be sourced by transistor 252 in the second current mirror. Thus, the second transistor 254 in the second current mirror 250 may generate a current $I_{SIG}$ at $I_B$.

Similarly, when $V_{INN}$ is at its maximum level, for example, then transistors 232 and 224 may be nearly fully conductive. At this same time, $V_{INP}$ will be at its minimum level, which may render transistors 222 and 234 minimally conductive. Thus, transistors 224 and 232 each may pass nearly all of the current ($I_B$) that their associated current mirror transistors 244 and 246 sink. The current passed by transistor 234 may be sourced by transistor 252 in the second current mirror. Thus, the second transistor 254 in the second current mirror 250 may generate a current $I_{SIG}$ at $I_B$.

Overall, during the ON phase, the $I_{SIG}$ current may vary in response to the $V_{INP}$ and $V_{INN}$ input signals as shown in FIG. 3. The $I_{SIG}$ current may be compared to the ½$I_B$ current that is sunk from the output terminal by the current mirror transistor 248. Thus, the receiver of FIG. 2 may generate an output current $I_{OUT}$ having the form illustrated in FIG. 3.

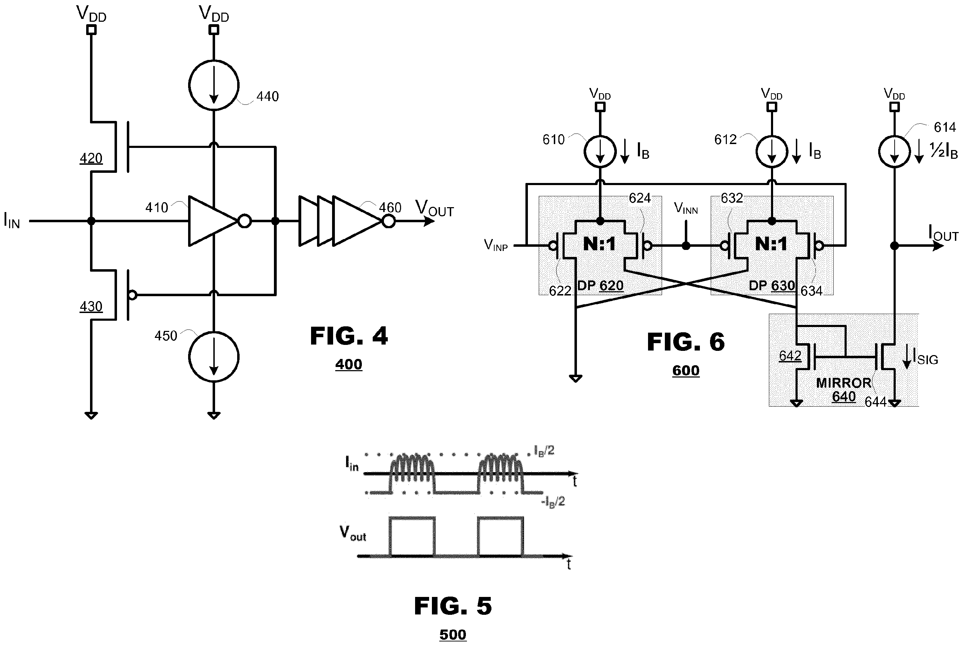

FIG. 4 illustrates a current comparator 400. The comparator 400 may include an inverter 410, a pair of pulling transistors 420, 430, current sources 440 and 450 and one or more inverters 460. The inverter 410 may accept a current input $I_{IN}$ on an input terminal. The input current may be an output current $I_{OUT}$ generated by a receiver such as those described in FIGS. 1, 2, 6 and 8 of this disclosure.

The input terminal $I_{IN}$ also may be connected to a first supply voltage $V_{DD}$ by a first transistor 420 and to a second supply voltage (shown as ground) by a second transistor 430. Gates of the transistors 420, 430 may be coupled to an output of the inverter 410. The transistors 420, 430 may provide a positive feedback control within the comparator 400 to pull an input signal in the direction of one of the supplies $V_{DD}$ or ground as the input current $I_{IN}$ drives the inverter's input in that direction.

The inverter 410 may be connected to the supply voltages $V_{DD}$ and ground by respective current sources 440, 450. During operation, the current sources 440, 450 may limit responsiveness of the inverter 410 to transitions in the input current signal $I_{IN}$, which helps to filter signal glitches and other transients that otherwise might by introduced by noise within the system.

The inverter(s) 460 may buffer a voltage output provided by the inverter 410. The inverters 460 may include filters or other signal conditioning circuits (not shown) to filter transients from the inverter's output. A voltage $V_{OUT}$ output from the inverters 460 may be output from the isolator system as a digital output signal.

FIG. 5 illustrates exemplary input and output signals that may be processed by the comparator 400 of FIG. 4. In FIG. 5, the input current $I_{IN}$ is shown as the output current signal $I_{OUT}$ in FIG. 3. The output signal generated from the input current $I_{IN}$ is shown as $V_{OUT}$.

FIG. 6 illustrates a receiver 600 . The receiver 600 may include a plurality of current sources 610, 612, 614, two differential pair circuits 620, 630 and a current mirror 640. The current sources 610 and 612 may supply currents to an associated differential pair circuit 620 or 630 at a first level $I_B$. The current source 614 may source current to an output terminal $I_{OUT}$ at a level that is half the level of current sources 610 and 620 (e.g., ½$I_B$).

The differential pair circuits 620, 630 each may include a pair of mismatched transistors 622, 624 for differential pair circuit 620 and 632, 634 for differential pair circuit 630. The transistors in each pair 620, 630 may be mismatched according to a predetermined sizing ratio, shown as N to 1. Thus, transistors 622 and 632 may be N times larger than their counterpart transistors 624 and 634. During operation, in response to a common control voltage, the transistors 622, 632 may pass N times more current than the counterpart transistors 624 and 634.

The input signal $V_{IN}$ may be a differential signal represented by component signals $V_{INN}$ and $V_{INP}$. Gates of transistors 622 and 634 may receive a first input voltage $V_{INP}$ and gates of the other transistors 624 and 632 may receive a second input voltage $V_{INN}$. Sources of the transistors 622, 624 in the first differential pair circuit 620 may be connected to a common node, which may be coupled to current source 610. Sources of the transistors 632, 634 in the second differential pair 630 may be connected to a second node, which may be coupled to another current source 620. Drains of the unit-sized transistors 624, 634 of the two differential pair circuits 620, 630 may be connected together and connected to a first transistor 642 in the second current mirror 640. Drains of the N-sized transistors 622, 632 of the two differential pair circuits 620, 630 may be connected to a voltage supply (ground, in this case).

The current mirror 640 may include a pair of transistors 642 and 644. As discussed, a first transistor 642 may be connected to the unit-sized transistors 624 and 634 of the differential pairs 620, 630. The second transistor 644 may be connected to the current source 614. The first transistor 642 may be provided in a diode-connected configuration. Thus, the current that passes through transistor 642 defines an amount of current that passes through transistor 644.

An output terminal $I_{OUT}$ of the receiver 600 may be provided at the connection between transistors 644 and current source 614. During operation, the transistor 644 and current source 614 perform a current comparison at the output terminal $I_{OUT}$. The current source 614 may source an amount of current to the output terminal equal to ½$I_B$. The transistor 644 may sink an amount of current $I_{SIG}$ from the output terminal $I_{OUT}$ in an amount that is determined by the differential pair circuits 620, 630, which in turn is determined by the input signals $V_{INP}$ and $V_{INN}$. When $I_{SIG} \neq$ ½$I_B$, a residual current is either sourced to or sunk from the output terminal $I_{OUT}$.

The circuit of FIG. 6 may operate in accordance with the principles discussed above with respect to FIG. 3. Here, the transistors 622-624, 632-634 of the differential pairs 620, 630 are illustrated as PMOS transistors rather than NMOS transistors as illustrated in FIG. 2 and, therefore, the conductivity of the transistors will be inverted from that of the FIG. 2 circuit during the ON phase. Nevertheless, the circuit of FIG. 6 may generate a signal current $I_{SIG}$ as illustrated in FIG. 3, which may be compared to the current ½$I_B$ of the current source 614 to generate the $I_{OUT}$ signal, also illustrated in FIG. 3.

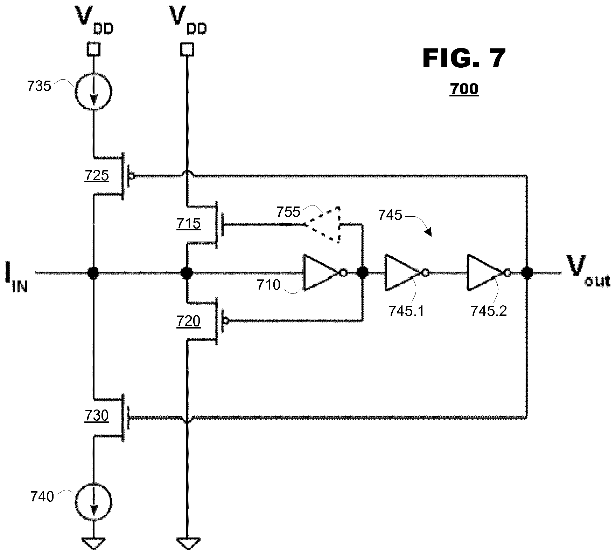

FIG. 7 illustrates an output driver 700. The output driver 700 may include an inverter 710, a pair of pulling transistors 715, 720, a pair of gating transistors 725, 730, a pair of current sources 735, 740 and one or more output inverters 745. An input current signal $I_{IN}$ may be input to an input of the inverter 710.

The pulling transistors 715, 720 may couple the input terminal $I_{IN}$ to respective high and low voltage supplies $V_{DD}$ and ground. Gates of the pulling transistors 715, 720 may be coupled to an output of the inverter 710.

The gating transistors 725 and 730 and current sources 735, 740 may be provided in pairs. A first transistor-current source pair 725, 735 may provide a second circuit path between the input terminal $I_{IN}$ and the high voltage supply $V_{DD}$ in parallel to a circuit path provided by the first pulling transistor 715. A second transistor-current source pair 730, 740 may provide a circuit path between the input terminal $I_{IN}$ and the low voltage supply (ground) in parallel to a circuit path that is provided by the second pulling transistor 720. The gating transistors and pulling transistors may be provided as complementary device types. In the example illustrated in FIG. 7, the first pulling transistor 715 is illustrated as an NMOS transistor and the first gating transistor 725 is illustrated as a PMOS transistor. Further, the second pulling transistor 720 is illustrated as a PMOS transistor and the second gating transistor 730 is illustrated as an NMOS transistor. Optionally, a buffer 755 may be provided in a circuit path from the inverter output chain to a gate of transistor 715.

Although the current sources 735, 740 are illustrated as ideal current sources, their operation may be gated by their associated transistors 725 and 730. Thus, current source 735 will not supply current when its associated transistor 725 is rendered non-conductive. Similarly, current source 740 will not drive current when its associated transistor 730 is non-conductive. Gates of the gating transistors 725, 730 may be coupled to a node after one of the inverters 745. The provision of current sources 735 and 740 adds a hysteresis effect to operation of the output driver 700 which reduces its sensitivity to noise and other short term transients in the input current $I_{IN}$.

The output driver 700 may include one or more output inverters 745. Two output inverters 745.1, 745.2 are illustrated in FIG. 7 although different implementations may include other numbers of inverters as may be desired. Increasing the number of inverters may increase the driver's resistance to transients in the input current signal but also may increase the latency of the driver's response to key changes in the input signal.

During operation, an input current $I_{IN}$ may be presented to the inverter 710, in the form illustrated in FIG. 3. Responsive to the input voltage, the inverter 710 may generate an output voltage at one of two levels, $V_{DD}$ or ground. The inverter's output may be input to the transistors 715-730. When the inverter's output is set to $V_{DD}$, the transistor 715 may become conductive, which allows the input current to pass to $V_{DD}$. The transistor 715 may be sized to weakly pull the input node to $V_{DD}$ as compared to pulls exerted by the inverter 710. When the inverter's output is set to ground, the transistor 720 may become conductive, which allows the input current to pass to ground. The transistor 720 also may be sized to weakly pull the input node to ground as compared to pulls exerted by the inverter 710.

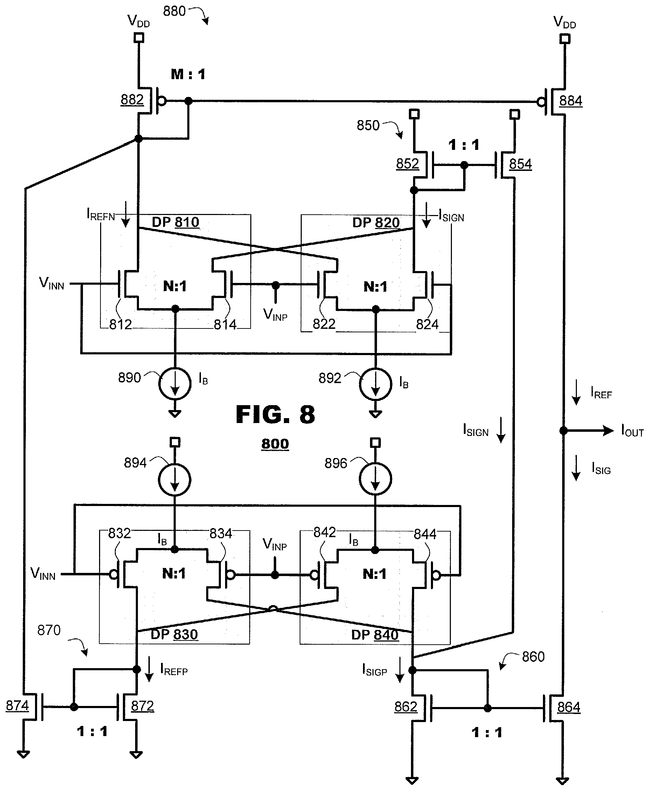

FIG. 8 illustrates a receiver circuit 800. There, the receiver 800 may include four differential pair circuits 810-840, several current mirrors 850-880, and a plurality of current sources 890-896. The differential pair circuits 810-840 each may include a pair of mismatched transistors, shown as having a ratio of N to 1. Two differential pair circuits 810, 820 may have transistors 812, 814, 822 and 824 of a first doping type (NMOS transistors, in the example illustrated in FIG. 8) and the other two differential circuits 830, 840 may have transistors 832, 834, 842, 844 of a complementary doping type (e.g., PMOS transistors, in this example). Tails of each of the differential pair circuits 810-840 may be connected to respective current sources 890-896.

The current mirrors 850-880 may be arranged to sum currents that pass through the N-sized transistors 812, 822, 832 and 842 and those that pass through the unit-sized transistors 814, 824, 834, 844. Current mirror 850, for example, may have a first leg, provided by transistor 852, that is coupled to the unit-sized transistors 814, 824 of differential pairs 810 and 820 and a second leg, provided by transistor 854 for an output current $ISIG_N$. The transistor 852 may be provided in a diode-connected configuration. Thus, an amount of current passed by the unit-sized transistors 814, 824 of the two differential pairs may be output to the second leg of the current mirror, also shown as $ISIG_N$.

The current mirror 860 may have a first leg, provided by transistor 862, that is coupled to the unit-sized transistors 834, 844 of differential pairs 830 and 840 and also to the output leg of current mirror 850. A second leg of the current mirror 860, provided by transistor 864, may be coupled to the output terminal $I_{OUT}$. The transistor 862 may be provided in a diode-connected configuration. Thus, the current mirror 860 may generate a current signal ISIG representing a sum between $ISIG_N$ and the current passed by the unit-sized transistors 834, 844 of the second pair of differential pair circuits 830, 840.

Similarly, current mirror 870 may have a first leg, provided by transistor 872, that is coupled to the N-sized transistors 832, 842 of differential pairs 830 and 840 and a second leg, provided by transistor 874 for an output current $IREF_P$. The transistor 874 may be provided in a diode-connected configuration. Thus, an amount of current passed by the N-sized transistors 832, 842 of the differential pairs 830 and 840 may be output to the second leg of the current mirror, also shown as $IREF_P$.

The current mirror 880 may have a first leg, provided by transistor 862, that is coupled to the N-sized transistors 812, 824 of differential pairs 810 and 820 and also to the output leg of current mirror 870. A second leg of the current mirror 880, provided by transistor 884, may be coupled to the output terminal $I_{OUT}$. The transistor 882 may be provided in a diode-connected configuration. Thus, the current mirror 880 may generate a current signal IREF representing a sum between IREFp and the current passed by the N-sized transistors 812, 822 of the second pair of differential pair circuits 810, 820.

In an example, the transistors 882, 884 of current mirror 880 may be mismatched transistors with transistor 882 being larger than transistor 884 (shown as being M times larger). In such an example, the transistor 882 would pass M times the current that transistor 884 passes. In other words, the current $I_{REF}$ would be to $1/M^{th}$ the current that passes through the N-sized transistors 812, 822, 832 and 842 of the differential pair circuits 810, 820, 830 and 840.

The output terminal $I_{OUT}$ of the receiver 800 may be provided at the connection between transistors 884 and 864. During operation, the current mirrors 860 and 880 may perform a current comparison at the output terminal $I_{OUT}$. The transistor 864 may sink an amount of current $I_{SIG}$ from the output terminal $I_{OUT}$ based on the amount of current sunk by the unit-sized transistors 814, 824, 834, 844 of the differential pair circuits 810, 820, 830 and 840. The transistor 884 may source an amount of current $I_{REF}$ to the output terminal $I_{OUT}$ based on the amount of current sunk by the N-sized transistors 812, 822, 832 and 842 of the differential pair circuits 810, 820, 830 and 840. When $I_{REF} \neq I_{SIG}$, a residual amount of current either would be sourced output from the receiver 800 or sunk by the receiver 800 through the $I_{OUT}$ terminal. During operation, the input signals $V_{INP}$ and $V_{INN}$ may toggle between two phases of operation according to the OOK signal structure of the system. In a first phase of operation, the OOK signal may be in an "OFF" state in which $V_{INP}$ and $V_{INN}$ are inactive signals. During this time, $V_{INP}$ and $V_{INN}$ each may have voltages of $\frac{1}{2}V_{DD}$ which may render all transistors of the differential pair circuits 810, 820, 830 and 840 partially conductive. The N-sized transistors 812, 822, 832 and 842 may induce a reference current through the current mirror 880 as $I_{REF} = \frac{4}{M} I_B$. The unit-sized transistors 814, 824, 834, 844 may induce a current through the current mirror 860 as $I_{SIG} = \frac{4}{N} I_B$. When N > M, then $I_{REF}$ > $I_{SIG}$ in the OFF state.

In the second phase of operation, the OOK signal may be in an "ON" state in which $V_{INP}$ and $V_{INN}$ are active signals. The $V_{INP}$ and $V_{INN}$ signals may oscillate between $V_{DD}$ and ground, centered about $\frac{1}{2}V_{DD}$. Again, $V_{INP}$ and $V_{INN}$ may not be full rail signals owing to losses within the circuit system. Conductivity of the transistors in the differential pair circuits 810, 820, 830 and 840 may vary according to these signals. The N-sized transistors 812, 822, 832 and 842 may induce a reference current as $4I_B$, which may be scaled down at the output node as $I_{REF} = \frac{4}{M} I_B$. The unit-sized transistors 814, 824, 834, 844 may induce a current as $I_{SIG} = 2I_B$. When M > 2, then $I_{SIG}$ > $I_{REF}$ in the ON state.

The parameters of N and M may be tuned to suit individual application needs. They should be set so that the current comparison at the output terminal ($I_{OUT}$) generates a first detectable state when the OOK signal is in an "OFF" state and another state when the OOK signal is in an "ON" state. Typically, M will be larger than 2.

The example of FIG. 8 provides several advantages over the design shown in, for example, FIG. 2. First, by providing differential pair circuits of two process types (e.g., both PMOS and NMOS), the receiver 800 will remain responsive to input signals at both extremes of an input voltage ($V_{DD}$ and ground). Transistors of each type may be non-responsive when a difference of voltages between their gates and their sources fail to overcome a $V_{GS}$ threshold inherent to those transistors. For NMOS transistors, the gate voltage must exceed the source voltage by the $V_{GS}$ thresholds and, when such transistors connect their sources to ground, the transistors may not be responsive to an input voltage that differs from ground by less than the transistor's $V_{GS}$ threshold. Similarly, for PMOS transistors, the gate voltage must be less than the source voltage by the $V_{GS}$ threshold and, when such transistors connect their sources to $V_{DD}$, the transistors may not be responsive to an input voltage that differs from $V_{DD}$ by less than the transistor's $V_{GS}$ threshold. In the circuit of FIG. 8, however, if the differential pairs of one doping type (say, those having the PMOS transistors) are non-responsive, the differential pairs of the complementary doping type may continue operation. Thus, the design of FIG. 8 may provide for rail-to-rail operation.

Further, the design of FIG. 8 may conserve resources as compared to the design of FIG. 2. Whereas, in the FIG. 2 example, current that passes through the N-sized transistors was sourced to the supplies ($V_{DD}$ and ground), in the FIG. 8 example the currents that are used in both the N-sized transistors and the unit-sized transistors are used to drive their respective current mirrors. Thus, the FIG. 8 example may provide for more efficient use of resources.

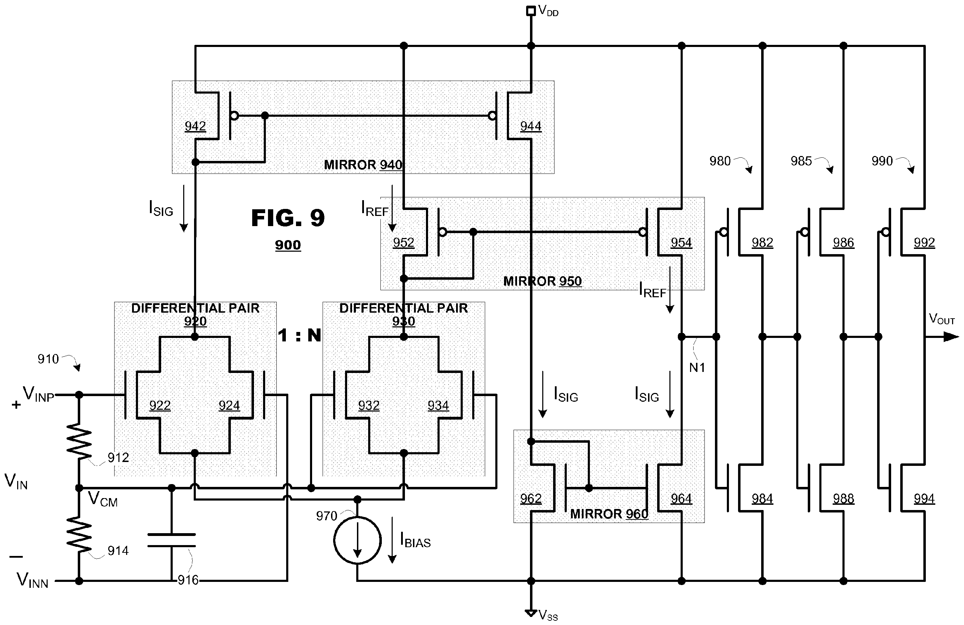

FIG. 9 illustrates a receiver 900 according to an embodiment of the present invention, which may be employed as a receiver in the system of FIG. 1. The receiver 900 may include a filter 910, two differential pair circuits 920, 930 acting as first and second receivers, current mirrors 940-960, a bias current source 970, and one or more output stages 980-990. The receiver 900 may accept a differential input signal $V_{IN}$ that is represented by component signals $V_{INN}$ and $V_{INP}$. The filter 910 is connected between inputs of the differential voltage source; it may generate a common mode voltage $V_{CM}$ between $V_{INN}$ and $V_{INP}$. The component signals $V_{INN}$ and $V_{INP}$ may be input to respective input terminals of a first differential pair circuit 920 and the common mode voltage may be input to both input terminals of a second differential pair circuit 930. The current mirrors 940-960 and output stages 980-990 may generate an output signal ($V_{OUT}$) from a comparison of currents drawn by the differential pair circuits 920, 930.

In an embodiment, the filter 910 may be an RC filter formed by bridging resistors 912, 914 and a capacitor 916. The RC filter 910 may reproduce the common mode voltage $V_{CM}$ of $V_{INN}/V_{INP}$. In this manner, the filter 910 may output a $V_{CM}$ signal that is nearly constant. Although the filter 910 is illustrated as formed of resistors 912 and 914, other components may be used. For example, the filter 910 may be formed of transistors (not shown) which are set to predetermined conductivity by application of bias voltages to their gates. The filter 910 may filter the common mode voltage $V_{CM}$ to suppress transients that may arise from electromagnetic events in an environment in which the isolator system 100 (FIG. 1) is to be used. Resistance and capacitance values of the RC filter may be selected to define a cut off frequency of the RC filter 910 that is much smaller than the carrier frequency. Circuit designers may size the capacitor 916 and resistors 912, 914 according to EMI transients that are expected to occur. The differential pair circuits 920, 930 may be mismatched. In this embodiment, a mismatch ratio (1:N) may defined between the differential pair circuits 920, 930. Thus, transistors 922, 924 of the first differential pair circuit 920 may have a ratio of 1 as compared to transistors 932, 934 of the second differential pair circuit 920. Thus, transistors 932, 934 may be N times larger than their counterpart transistors 922, 924. During operation, in response to a common control voltage, the transistors 932, 934 may pass N times more current than the counterpart transistors 922, 924.

As discussed, the input signal $V_{IN}$ may be a differential signal represented by component signals $V_{INN}$ and $V_{INP}$. The first differential pair circuit 920 may receive the input signal $V_{IN}$ and, thus, a gate of a first transistor 922 may receive one of the component signals $V_{INP}$ and a gate of a second transistor 924 may receive the second component signal $V_{INN}$. Drains of the transistors 922, 924 may be connected together and connected to a first transistor 942 in a first current mirror 940. Sources of the transistors 922, 924 may be connected to the bias current source 970 and to the filter 910.

In the second differential pair circuit 930, gates of the transistors 932, 934 each may receive the common mode signal VCM that is generated by the filter 910. Drains of the transistors 932, 934 may be connected together and connected to a first transistor 952 in a second current mirror 950. Sources of the transistors 932, 934 may be connected to the bias current source 970 and to the filter 910.

During operation, the differential pair circuit 920, 930 will pass an amount of current that, collectively, equals an amount of current $I_{BIAS}$ sunk by the bias current source 970. When an input signal $V_{IN}$ is close to the common mode voltage ($V_{INP} \cong V_{INN} \cong V_{CM}$), the four transistors 922, 924, 932, 934 will have approximately equal bias voltage but, owing to the larger size of the transistors 932, 934, the second differential pair circuit 930 will pass N times more current than the first differential pair circuit 920. When the input signal $V_{IN}$ is close to its limits (e.g., $|V_{INP}| \cong |V_{INN}| \cong V_{DD}$), then one of the transistors 922, 924 in the first differential pair circuit (say, 920) will be highly conductive, another one of the transistors 924 will be non-conductive, and the transistors 932, 934 of the second differential pair circuit 930 will have intermediate conductivity. In this latter case, the first differential pair circuit 920 will pass more current than the second differential pair circuit 930. Thus, the differential pair circuits 920, 930 will sink different proportions of the bias current $I_{BIAS}$ as $V_{IN}$ varies.

The currents of the first and second differential pair circuit 920, 930 may be compared at a predetermined node N1. In the configuration illustrated in FIG. 9, the second current mirror 950 includes an output transistor 954 that is coupled between a first supply voltage (here, $V_{DD}$).

Thus, the current mirror 950 attempts to replicate a current $I_{REF}$ that passes through the second differential pair circuit 930, which passes also through the first transistor 952 of the mirror 950, on a circuit path that includes the second transistor 954. The receiver 900 also includes a pair of current mirror circuits 940, 960 that attempt to replicate a current $I_{SIG}$ that passes through the first differential pair circuit 920, which passes also through the first transistor 942 of current mirror 940, on a circuit path that includes the second transistor 964 of mirror circuit 960. The first mirror 940 replicates $I_{SIG}$ at its output transistor 944, which is input to a first transistor 962 of the third current mirror 960 and is output at its second transistor 964.

Because $I_{SIG} \neq I_{REF}$ in many conditions, the current mirrors 950, 960 likely will not operate as ideal current sources in all conditions. Nevertheless, the current mirrors 950, 960 operate to compare the currents $I_{SIG}$, $I_{REF}$ from the different pair circuits 920, 930 at node N1. When $I_{REF} > I_{SIG}$, which likely will occur when $V_{INP} \cong V_{INN} \cong V_{CM}$, a voltage at node N1 likely will transition toward $V_{DD}$. When $I_{REF} < I_{SIG}$, which likely will occur when $|V_{INP}| \cong |V_{INN}| \cong V_{DD}$, a voltage at node N1 likely will transition toward Vss. Thus, the voltage at N1 may indicate the state of an OOK signal that is input to the receiver as $V_{IN}$.

The receiver 900 may include one or more output stages 980-990 to generate a binary output signal from the voltage generated at node N1 from the comparison of $I_{SIG}$ to $I_{REF}$. In the configuration illustrated in FIG. 9, the output stages 980-990 are illustrated as pairs of transistors 982 and 984, 986 and 988, and 992 and 994 connected as inverters. The number of output stages may be tailored to fit individual circuit needs, not only to provide protection against common mode transients but also to tailor polarity of the output signal to OOK events (e.g., whether an ON state or an OFF state corresponds to a $V_{OUT}$ of "1"). In an alternative configuration, one or more of the output stages 980-990 may be provided as a Schmitt trigger circuit (not shown), which may provide an inherent hysteresis to signal transitions and provide further protection against common mode transient events. Moreover, the output stage(s) may be provisioned as shown in FIGS. 4 and/or 7.

In the embodiment of FIG. 9, the degree of mismatch between transistors 922, 924 and 932, 934 of the first and second differential pair circuits 920, 930 can be made smaller than in the embodiment illustrated in FIGS. 2, 6 and 8. In the FIG. 9 implementation, $N \geq 2$ where, as discussed in the FIG. 2 embodiment, $N \geq 10$. Thus,

the FIG. 9 embodiment is expected to provide common mode transient protections using a circuit with lower manufacturing cost than the embodiment of FIG. 2.

In the embodiment illustrated in FIG. 9, the transistors are illustrated as MOSFET transistors and, specifically, transistors 922-924, 932-934, 962-964 and 984, 988 and 994 are illustrated as NMOS transistors and transistors 942-944, 952-954, 982, 986 and 992 are illustrated as PMOS transistors. The principles of the present invention apply to transistors of other process technologies, such as BJT transistors and the like. Moreover, as discussed hereinbelow, process types may be inverted (e.g., PMOS transistors may be provided where NMOS transistors are illustrated and NMOS transistors may be provided where PMOS transistors are illustrated) with appropriate inversion of supply voltages. Such variations are immaterial to the principles of the present invention unless mentioned herein.

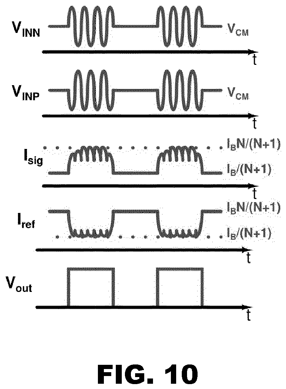

FIG. 10 illustrates exemplary signals that may be carried by the receiver 900 of FIG. 9. As illustrated, an input signal may be presented to the receiver 900 as input signal pairs $V_{INP}$ and $V_{INN}$ which are differential signals that vary about a common mode voltage $V_{CM}$. The differential pair circuits 920, 930 may generate respective $I_{SIG}$ and $I_{REF}$ current signals in response to the input signal, which are mirrored to the common node N1. Thereafter, the receiver 900 may generate an output signal $V_{OUT}$ from a comparison of the $I_{SIG}$ and $I_{REF}$ current signals.

As illustrated in FIG. 1, the receivers of the foregoing embodiments may be used cooperatively with a transmitter 110 that operates in a separate voltage domain that is isolated from a voltage domain of the receiver by an isolation boundary 150. Exemplary transmitters are illustrated in a co-pending application, filed September 15, 2014, entitled "Methods and Structures to Generate On/Off Keyed Carrier Signals for Signal Isolators," s.n. 14/486,937 (attorney docket 13641/518001. The foregoing description has presented a receiver circuit for an on-off keyed signal isolator. Although MOS transistors have been illustrated herein, the principles of the present invention find application with other process technologies, for example, bipolar junction transistors and junction field effect transistors.

Several embodiments of the invention are specifically illustrated and/or described herein. However, it will be appreciated that modifications and variations of the invention are covered by the above teachings and within the purview of the appended claims without departing from the scope of the appended claims. Further variations are permissible that are consistent with the principles described above.

## Claims

1. An on-off key, OOK, receiver system, comprising:

a first receiver (920) that generates a first current signal representing a received OOK signal, wherein the first receiver comprises a first differential pair circuit,
a second receiver (930) that generates a second current signal from a common mode representation of the received OOK signal, wherein the second receiver comprises a second differential pair circuit, the transistors of the second differential pair circuit being larger than the respective transistors of the first differential pair circuit,
a common current source (970) coupled to the first and second receivers, and
a comparator to generate an output signal representing a comparison of the first and second current signals, the comparator comprising a network of current mirrors, the network having a first current mirror (940) connected to the first receiver, a second current mirror (950) connected to the second receiver, a third current mirror (960) connected to the first and second current mirrors, wherein the network has a pair of outputs coupled to a common node for the first and second current signals, wherein the comparator comprises an output system to generate a binary output voltage.

2. The system of claim 1, wherein the output system includes at least one inverter on a signal path between the current comparison and the output signal.

3. The system of claim 1, wherein the output system comprises a plurality of serially-connected inverters.

4. The system of claim 1, 2 or 3, wherein the output system includes at least one Schmitt trigger on a signal path between the current comparison and the output signal.

5. The system of claim 2, further comprising a filter coupled to an output of the at least one inverter.

6. The system of any preceding claim, comprising:

a voltage divider connected across differential inputs to the receiver system,
wherein the first receiver has inputs coupled to the differential inputs to the receiver system, and the second receiver has inputs coupled to an intermediate node of the voltage divider.

7. A method of demodulating by generating a digital voltage signal representing a differential on-off keyed input signal, comprising:

generating a first current signal representing activity of a differential OOK signal received by an isolator device,

generating a second current signal representing a common mode level of the differential OOK signal,

comparing the first and second current signals, and

generating a binary voltage signal from the current comparison.

8. The method of claim 7, wherein the second current signal has a magnitude that is larger than a magnitude of the first current signal when the differential OOK signal is inactive.

9. The method of claim 7 or 8, wherein the comparing comprises routing replicated versions of the first and second current signals to a common node at different orientations to each other.

**Patentansprüche**

1. On-Off-Umtastungs-, OOK-Empfängersystem, umfassend:

einen ersten Empfänger (920), der ein erstes Stromsignal generiert, welches ein empfangenes OOK-Signal repräsentiert, wobei der erste Empfänger einen ersten Differentialpaarschaltkreis umfasst,

einen zweiten Empfänger (930), der ein zweites Stromsignal aus einer Gleichtaktdarstellung des empfangenen OOK-Signals generiert, wobei der zweite Empfänger einen zweiten Differentialpaarschaltkreis umfasst, wobei die Transistoren des zweiten Differentialpaarschaltkreises größer als die jeweiligen Transistoren des ersten Differentialpaarschaltkreises sind,

eine gemeinsame Stromquelle (970), die an den ersten und den zweiten Empfänger gekoppelt ist, und

einen Komparator, um ein Ausgabesignal zu generieren, welches einen Vergleich des ersten und zweiten Stromsignals repräsentiert, wobei der Komparator ein Netzwerk von Stromspiegeln umfasst, wobei das Netzwerk einen ersten Stromspiegel (940), der mit dem ersten Empfänger verbunden ist, einen zweiten Stromspiegel (950), der mit dem zweiten Empfänger verbunden ist, einen dritten Stromspiegel (960) aufweist, der mit dem ersten und dem zweiten Stromspiegel verbunden ist, wobei das Netzwerk ein Paar von Ausgängen aufweist, die an einen gemeinsamen Knoten für das erste und das zweite Stromsignal gekoppelt sind, wobei der Komparator ein Ausgabesystem umfasst, um eine binäre Ausgabespannung zu generieren.

2. System nach Anspruch 1, wobei das Ausgabesystem mindestens einen Inverter auf einem Signalpfad zwischen dem Stromvergleich und dem Ausgabesignal einschließt.

3. System nach Anspruch 1, wobei das Ausgabesystem eine Vielzahl von seriell verbundenen Invertern umfasst.

4. System nach Anspruch 1, 2 oder 3, wobei das Ausgabesystem mindestens einen Schmitt-Trigger auf einem Signalpfad zwischen dem Stromvergleich und dem Ausgabesignal einschließt.

5. System nach Anspruch 2, ferner umfassend einen Filter, der an eine Ausgabe des mindestens einen Inverters gekoppelt ist.

6. Verfahren nach einem der vorhergehenden Ansprüche, umfassend:

einen Spannungsteiler, der über Differentialeingänge mit dem Empfängersystem verbunden ist,

wobei der erste Empfänger Eingänge aufweist, die an die Differentialeingänge an dem Empfängersystem gekoppelt sind, und der zweite Empfänger Eingänge aufweist, die an einen Zwischenknoten des Spannungsteilers gekoppelt sind.

7. Verfahren zum Demodulieren, indem ein digitales Spannungssignal generiert wird, welches ein Differential-On-Off-umgetastetes Eingabesignal repräsentiert, umfassend:

Generieren eines ersten Stromsignals, welches Aktivität eines Differential-OOK-Signals repräsentiert, das durch eine Isolatorvorrichtung empfangen wurde,

Generieren eines zweiten Stromsignals, welches einen Gleichtaktpegel des Differential-OOK-Signals repräsentiert, Vergleichen des ersten und des zweiten Stromsignals, und

Generieren eines binären Spannungssignals aus dem Stromvergleich.

8. Verfahren nach Anspruch 7, wobei das zweite Stromsignal eine Größe aufweist, die größer als eine Größe des ersten Stromsignals ist, wenn das Differential-OOK-Signal inaktiv ist.

9. Verfahren nach Anspruch 7 oder 8, wobei das Vergleichen Routen von replizierten Versionen des ersten und zweiten Stromsignals an einen gemeinsamen Knoten in unterschiedlichen Orientierungen zueinander umfasst.

## Revendications

1. Système de réception de touche Marche/Arrêt, OOK, comprenant :

   - un premier récepteur (920) qui génère un premier signal de courant représentant un signal OOK reçu, dans lequel le premier récepteur comprend un premier circuit à paire différentielle,
   - un second récepteur (930) qui génère un second signal de courant à partir d'une représentation de mode commun du signal OOK reçu, dans lequel le second récepteur comprend un second circuit à paire différentielle, les transistors du second circuit à paire différentielle étant plus grands que les transistors respectifs du premier circuit à paire différentielle,
   - une source de courant commune (970) couplée aux premier et second récepteurs, et
   - un comparateur pour générer un signal de sortie représentant une comparaison des premier et second signaux de courant, le comparateur comprenant un réseau de miroirs de courant, le réseau ayant un premier miroir de courant (940) connecté au premier récepteur, un second miroir de courant (950) connecté au second récepteur, un troisième miroir de courant (960) connecté aux premier et second miroirs de courant, dans lequel le réseau comporte une paire de sorties couplées à un noeud commun pour les premier et second signaux de courant, dans lequel le comparateur comprend un système de sortie pour générer une tension de sortie binaire.

2. Système selon la revendication 1, dans lequel le système de sortie comporte au moins un onduleur sur un chemin de signal entre la comparaison de courant et le signal de sortie.

3. Système selon la revendication 1, dans lequel le système de sortie comprend une pluralité d'onduleurs connectés en série.

4. Système selon la revendication 1, 2 ou 3, dans lequel le système de sortie comporte au moins une bascule de Schmitt sur un chemin de signal entre la comparaison de courant et le signal de sortie.

5. Système selon la revendication 2, comprenant en outre un filtre couplé à une sortie de l'au moins un onduleur.

6. Système selon l'une quelconque des revendications précédentes, comprenant :

   - un diviseur de tension connecté par des entrées différentielles au système de réception,

dans lequel le premier récepteur comporte des entrées couplées aux entrées différentielles du système de réception, et le second récepteur comporte des entrées couplées à un noeud intermédiaire du diviseur de tension.

7. Procédé de démodulation en générant un signal de tension numérique représentant un signal d'entrée modulé on-off différentiel, comprenant :

   - la génération d'un premier signal de courant représentant l'activité d'un signal OOK différentiel reçu par un dispositif d'isolation,
   - la génération d'un second signal de courant représentant un niveau de mode commun du signal OOK différentiel,
   - la comparaison des premier et second signaux de courant, et
   - la génération d'un signal de tension binaire à partir de la comparaison de courant.

8. Procédé selon la revendication 7, dans lequel le second signal de courant a une amplitude qui est supérieure à une amplitude du premier signal de courant quand le signal OOK différentiel est inactif.

9. Procédé selon la revendication 7 ou 8, dans lequel la comparaison comprend l'acheminement de versions reproduites des premier et second signaux de courant à un noeud commun dans des orientations mutuellement différentes.

**FIG. 1**

**100**

**FIG. 2**

200

**FIG. 3**

300

EP 3 157 219 B1

13

**FIG. 6**
**600**

**FIG. 4**
**400**

**FIG. 5**
**500**

FIG. 7
700

**FIG. 8**

**800**

FIG. 9
900

MIRROR 940

MIRROR 950

MIRROR 960

DIFFERENTIAL PAIR 920

DIFFERENTIAL PAIR 930

1 : N

$I_{SIG}$

$I_{REF}$

$I_{REF}$

$I_{SIG}$

$I_{SIG}$

$V_{DD}$

$V_{SS}$

$V_{INP}$

$V_{IN}$

$V_{CM}$

$V_{INN}$

$V_{OUT}$

$I_{BIAS}$

N1

EP 3 157 219 B1

**FIG. 10**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2006202721 A
- WO 9717763 A
- EP 1753129 A
- US 8502584 B
- WO 14486937 A